(19) Europäisches Patentamt
European Patent Office
Office européen des brevets

(11) EP 2 685 448 B1

(12) # EUROPEAN PATENT SPECIFICATION

(45) Date of publication and mention of the grant of the patent:
**05.09.2018 Bulletin 2018/36**

(51) Int Cl.:
***G10H 1/08*** (2006.01) ***B60Q 5/00*** (2006.01)
***G10K 15/02*** (2006.01)

(21) Application number: **12176133.2**

(22) Date of filing: **12.07.2012**

(54) **Engine sound synthesis**

Motorenklangsynthese

Synthèse de son moteur

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**15.01.2014 Bulletin 2014/03**

(73) Proprietor: **Harman Becker Automotive Systems GmbH**
**76307 Karlsbad (DE)**

(72) Inventor: **Christoph, Markus**
**94315 Straubing (DE)**

(74) Representative: **Westphal, Mussgnug & Partner Patentanwälte mbB**
**Werinherstrasse 79**
**81541 München (DE)**

(56) References cited:
**EP-A1- 1 577 879** **WO-A1-01/33543**
**WO-A1-2009/028790** **US-A- 5 410 606**

- **SEN M KUO ET AL: "Frequency-Domain Periodic Active Noise Control and Equalization", IEEE TRANSACTIONS ON SPEECH AND AUDIO PROCESSING, IEEE SERVICE CENTER, NEW YORK, NY, US, vol. 5, no. 4, 1 July 1997 (1997-07-01), XP011054259, ISSN: 1063-6676**
- **DAS D P ET AL: "New block filtered-X LMS algorithms for active noise control systems", 20070607, vol. 1, no. 2, 7 June 2007 (2007-06-07), pages 73-81, XP006028980,**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 685 448 B1

## Description

### Technical Field

Various embodiments relate to the field of sound synthesis, particularly to synthesizing the sound of a combustion engine.

### Background

The growing popularity of hybrids and electric vehicles gives rise to new safety issues in urban environments, as many of the aural cues associated with (combustion) engine noise can be missing. The solution is to intelligently make vehicles noisier. In fact, several countries have established laws which require cars to radiate a minimum level of sound in order to warn other traffic participants of an approaching car.

A method for producing and using a sound effect library representing the sound characteristics of a motor vehicle is described in the publication WO 01/33543 A1. The paper S. M. Kuo, "Frequency-Domain Periodic Active Noise Control and Equalization", in IEEE Trans. on Speech and Audio Processing, Vol. 5, NO. 4, 1997, p. 348-358, analyzes a frequency-domain periodic active noise control (ANC) system. A least-mean-square (LMS) algorithm used in ANC systems is discussed in the paper D. P. Das, G. Panda, S. M. Kuo, "New block filtered-X LMS algorithms for active noise control systems", in: IET Signal Processing, Vol. 1, No. 2, 2007, p. 73-81. The publications US 5,410,606 and EP 1 577 879 A1 also relate to the field of noise cancelling. The publication WO 2009/028790 A1 deals with a method for encoding and decoding media signals.

Some research has been conducted in the field of analyzing and synthesizing sound signals, particularly in the context of speech processing. However, the known methods and algorithms typically require powerful digital signal processors which are not suitable for low-cost applications, as required in the automotive industry. Thus there is a need for an efficient method for synthesizing sound, particularly the sound of a combustion engine.

### Summary

A method for analyzing sound is described and defined in the appended claim 1. In accordance with one example of the invention the method includes: providing an input sound signal to be analysed and determining a fundamental frequency of the input signal from the input signal or from at least one guide signal. Furthermore, the frequencies of higher harmonics of the fundamental frequency are determined, thus determining harmonic model parameters. A harmonic signal based on the harmonic model parameters is synthesized and a residual signal is estimated by subtracting the harmonic signal from the input signal. Residual model parameters are estimated based on the residual signal.

Furthermore, a method for synthesizing a sound signal is described and defined in appended claim 11. The synthesizing is based on harmonic model parameters and residual model parameters that may be, for example, determined in accordance with the analysing method described above. In accordance with one example, the method includes: receiving at least one guide signal and calculating the fundamental frequency and frequencies of a number of higher harmonics based on the at least one guide signal. Furthermore, the residual model parameters and the harmonic model parameters that are associated with the calculated frequencies are provided. A harmonic signal is synthesized using the harmonic model parameters for the calculated fundamental frequency and frequencies of higher harmonics. Additionally, a residual signal is synthesized using the residual model parameters. The total sound signal is calculated by superposing the synthesized harmonic signal and residual signal.

### Brief description of the Drawings

The various embodiments can be better understood with reference to the following drawings and descriptions. The components in the figures are not necessarily to scale, instead emphasis is placed upon illustrating the principles of the invention. Moreover, in the figures, like reference numerals designate corresponding parts. In the drawings:

FIG. 1 is a block diagram illustrating a general example of analyzing engine sound based on a sinusoid signal model;

FIG. 2 is a block diagram illustrating one example of analyzing engine sound based on a model which utilizes an external guiding signal for estimating the harmonic sinusoid signal content that is present in an input signal;

FIG. 3 is a block diagram of another example of analyzing engine sound using an adaptive guided estimation of the harmonic sinusoid signal content;

FIG. 4 is a block diagram illustrating the adaptation of a harmonic sinusoid signal component in the example of FIG. 3; and

FIG. 5 is a block diagram illustrating the synthesis of engine sound using signal models obtained by the signal analysis in accordance with one of the examples of FIGs. 1 to 3.

## Detailed Description

One or more embodiments are described in the context of engine or motor sound synthesis. However, the methods for analyzing and synthesizing sound presented herein may also be applied outside the automotive field, as well as for other purposes. As mentioned above, it may be required for electric or hybrid cars to radiate a minimum level of sound to allow people, particularly pedestrians and people with reduced hearing capabilities, to hear an approaching car. The typical sound of a combustion engine may also be desired in the interior of a car to provide the driver with an acoustic feedback about the operational status of the car (with regard to the throttle control or the like). The sound perceivable from the outside of a car is dominated by the engine sound for a driving speed up to 30 to 40 km per hour. Therefore, particularly in urban regions where the driving speeds are low, the sound of the engine is the dominant "alarm signal" that warns other traffic participants of an approaching car.

In many applications, the signals of interest are composed of a plurality of sinusoidal signal components corrupted by broadband noise. For analysing and modelling such signals a sinusoidal or "harmonic" model is appropriate. In addition, signals mainly consisting of sinusoidal components can be found in different applications such as, e.g., formant frequencies in speech processing. Sinusoidal modelling may also be successfully applied for analysing and synthesizing the sound produced by musical instruments since they generally produce harmonic or nearly harmonic signals with relatively slowly varying sinusoidal components. Sinusoidal modelling offers a parametric representation of audible signal components such that the original signal can be recovered by synthesis, i.e. by addition (i.e. superposition) of the (harmonic and residual) components.

Rotating mechanical systems such as the combustion engine of a car have a high harmonic content plus a broadband noise signal and thus a "sinusoids plus residual" model is well suitable for analyzing and synthesizing the sound produced by a real world combustion engine. For this purpose the sound generated by a combustion engine may be recorded using one or more microphones positioned outside the car while the car is placed, e.g., in a chassis roller dynamometer and operated in different load conditions and at various rotational engine speeds. The resulting audio data may be analyzed to "extract" model parameters from the audio data which may be later used (e.g., in an electric car) to reproduce the motor sound in an easy manner by using an appropriate synthesizer. The model parameters are generally not constant but may vary particularly dependent on the rotational engine speed.

FIG. 1 illustrates a system for analysing an audio signal in the frequency domain to extract the mentioned model parameters. The time discrete (with time index n) input signal x[n] is the audio data obtained by measurement as discussed above. In FIG. 1 the measurement is symbolized generally by an input signal source 10 providing the input signal x[n]. The signal x[n] may be transformed into the frequency domain using a digital short-time Fourier transform (STFT) algorithm (e.g., a FFT algorithm). The function block that performs the STFT for generating the input signal $X(e^{j\omega})$ in the frequency domain is labelled with the reference numeral 20 in FIG. 1. Starting with the input signal $X(e^{j\omega})$ in the frequency domain all the following signal analysis is conducted in the frequency domain. The signal processing is, however, not limited to the frequency domain. The signal processing may be performed partially or even exclusively in the time domain. When using frequency domain signal processing the number of harmonic sinusoids is, however, only limited by the FFT-length used.

In accordance with the system illustrated in FIG. 1 the input signal $X(e^{j\omega})$ may be supplied to a function block 30 performing the estimation of the sinusoidal signal components. In the present example this function is divided in two parts, namely the estimation of the fundamental frequency $f_0$ (function block 31) and the estimation of the N harmonic sinusoids (function block 32) having the frequencies $f_1, f_2, ..., f_N$. Many methods are known in the field for accomplishing this task and are not further discussed here in detail. All methods, however, are based on a signal model which can be expressed as follows:

$$x[n] = A_0 \cdot \sin(\omega_0 n + \varphi_0) + A_1 \cdot \sin(\omega_1 n + \varphi_1) + \ldots + A_N \cdot \sin(\omega_N n + \varphi_N) + r[n] \qquad (1)$$

That is, the input signal x[n] is modeled as a superposition of the following: a sinusoid signal having the fundamental frequency $f_0$ (corresponds to the angular frequency $\omega_0$), N harmonic sinusoids having the frequencies $f_1$ to $f_N$ (correspond to the angular frequencies $\omega_1$ to $\omega_N$, respectively), and a broadband, non-periodic residual signal r[n]. The result of the sinusoidal signal estimation (block 30) are three corresponding vectors including the estimated frequencies $f = (f_0, f_1, ..., f_N)$ as well as the corresponding magnitudes $A = (A_0, A_1, ..., A_N)$ and phase values $\varphi = (\varphi_0, \varphi_1, ..., \varphi_N)$,

wherein the phase $\varphi_0$ of the fundamental frequency may be set to zero. These vectors f, A, $\varphi$ containing frequency, magnitude and phase values may be determined for various different fundamental frequencies, e.g. corresponding to rotational speeds of the engine of 900 rpm, 1000 rpm, 1100 rpm, etc. Further, the vectors f, A, $\varphi$ may be determined for different engine loads or for other non-acoustical parameters (gear number, reverse gear active, etc.) which represent the operational mode of the engine.

To estimate the residual signal r[n], which may also be dependent on one or more non-acoustical parameters (gear number, reverse gear active, etc.), the estimated model parameters, i.e. the vectors f, A, and $\varphi$ are used to synthesize the total (estimated) harmonic content of the input signal by superposition of the individual sinusoids. This is accomplished by block 40 in FIG. 1 and the resulting estimated harmonic portion of the input signal is denoted as $H(e^{j\omega})$ in the frequency domain and as h[n] in the time domain. The synthesized signal $H(e^{j\omega})$) may be subtracted (see block 50) from the input signal $X(e^{j\omega})$ to obtain the residual signal $R(e^{j\omega})$, which is the frequency domain equivalent of the time domain signal r[n] mentioned before. The residual signal may be subject to filtering (e.g. a non-linear smoothing filter 60). Such a filter may be configured to smooth the residual signal, i.e., to suppress transient artefacts, spikes, or the like in the estimated residual signal $R(e^{j\omega})$. The filtered residual signal $R'(e^{j\omega})$ is supplied to block 70 which represents the signal analysis performed to obtain model parameters characterising the residual signal. This signal analysis may include, for example, linear predictive coding (LPC) or simply the calculation of the power spectrum of the residual signal. For example, the power spectrum of the residual signal may be calculated in different spectral regions (frequency bands in accordance to a psycho-acoustically motivated frequency scale, see, e.g., Fastl, Hugo; Zwicker, Eberhard; Psychoacoustics (3rd. edition), Springer, 2007) which may be chosen to consider psycho-acoustically critical band limits. Using a psycho- acoustically motivated frequency scale such as the Bark or the Mel scale allows a massive reduction in computation time and memory usage.

Having thus obtained the "harmonic" signal model parameters for different fundamental frequencies as well as the residual signal model parameters for different non-acoustical parameters (e.g. rotational speed values of the engine, gear number, engine load, etc.), these model parameters may later be used to synthesize a realistic engine sound which corresponds to the sound produced by the engine analysed in accordance with FIG. 1.

FIG. 2 illustrates another example of the signal analysis which can be seen as an alternative to the signal analysis in accordance with FIG. 1. The structure of the signal analysis of FIG. 2 corresponds to the one of FIG. 1 except the functional principle of the sinusoidal signal estimation 30. The remaining parts of the block diagram of FIG. 2 are identical with the example of FIG. 1. In the present example, a guided harmonic sinusoid estimation is performed wherein, e.g. the rpm signal rpm[n] is used as a guide signal. In this context, the rpm signal may generally be a signal representing the rotational speed of the engine, which may be provided, e.g., by the engine control unit (also known as power train control module which is usually accessible in many cars via the CAN bus, CAN = controller area network). When using a guided sinusoid estimation the fundamental frequency is not estimated from the input signal $X(e^{j\omega})$ but rather may be directly obtained from the guide signal which is, in the present example, the rpm signal rpm[n] of the engine under test. For example, an engine speed of 1200 revolutions per minute results in a fundamental frequency of 120 Hz for a six-cylinder combustion engine.

For a guided sinusoid signal estimation the following signal model may be used. Accordingly, the input signal x[n] is modelled as

$$x[n] = \sum_{i=1,2,\ldots} A_i \cdot \sin(2\pi \cdot i \cdot f_0 \cdot n + \varphi_i) \qquad (2)$$

wherein n is the time index, i denotes the number of the harmonic, $f_0$ denotes the fundamental frequency, and $A_i$ and $\varphi_i$ are the phase and amplitude, respectively, of the $i^{th}$ harmonic. As mentioned above, the fundamental frequency and the frequencies of the higher harmonics are not estimated from the input signal x[n] but can be directly derived from the guide signal rpm[n]. This functionality is represented by the block labelled "generation of N harmonic sinusoids" in FIG. 2. The corresponding amplitude $A_i$ and phase values $\varphi_i$ are estimated using signal processing methods which are, as such, known in the field. For example, Fast Fourier Transform (FFT) algorithms may be used or alternatively, the Goertzel algorithm may be used if only a few harmonics are to be estimated. Usually a fixed number N of frequencies is considered. One example of guided harmonic estimation in the context of speech processing is, e.g., described in Christine Smit and Daniel P. W. Ellis, GUIDED HARMONIC SINUSOID ESTIMATION IN A MULTI-PITCH ENVIRONMENT, in: 2009 IEEE Workshop on Applications of Signal Processing to Audio and Acoustics, Oct. 18-21 2009.

FIG. 3 illustrates a modification of the example presented in FIG. 2. Both block diagrams are essentially identical except the signal processing block 30 representing the sinusoidal signal estimation. The guided adaptive sinusoid estimation algorithms may take the frequency vector f including the fundamental frequency $f_0$ and the frequency of at least one higher harmonic ($f_1$, $f_2$, etc.) as parameter and adaptively "fine-tunes" these frequencies to best match the input signal $X(e^{j\omega})$. Accordingly, the estimation may provide a modified frequency vector f' including the fine-tuned

frequencies $f_0'$, $f_1'$, etc. as well as the corresponding amplitude vector A'=[$A_0'$, $A_1'$, $A_2'$, ...] and phase vector φ=[$\varphi_0'$, $\varphi_1'$, $\varphi_2'$, ...]. An adaptive algorithm may be used, particularly in cases when the guide signal (e.g., the rpm signal rpm[n]) is of insufficient quality. Mechanical systems such as the power train of an automobile usually have a very high Q-factor and thus even small deviations (in the range of a few Hertz) between the rpm signal rpm [n] and the true engine speed may significantly deteriorate the estimation result, particularly for higher harmonics.

FIG. 4 is a block diagram illustrating one exemplary procedure for adapting one frequency $f_i$ (i=1, ..., N) component (as well as its amplitude $A_i$ and its phase $\varphi_i$) included in the frequency vector f using a least mean square (LMS) optimization algorithm. The result of the adaptation is a "fine-tuned" sinusoid represented by the triple $f_i'$, $A_i'$, $\varphi_i'$. Starting point for the adaptation is a sinusoid (represented by the triple $f_i$, $A_i$, $\varphi_i$) estimated using the basic approach as described with reference to FIG. 2. That is, the initial values $f_i'$, $A_i'$, $\varphi_i'$, which are then optimized using the adaptive algorithm described herein, may be obtained using a guided harmonic sinusoid estimation with which the frequencies $f_i$ (i=1, 2, ..., N) are simply calculated as multiples of the fundamental frequency $f_0$ which is directly derived from a (non-acoustical or acoustical) guide signal, e.g., from a rotational speed signal in an automotive application. For the adaptation the initial sinusoid represented by the triple triple $f_i$, $A_i$, $\varphi_I$ is regarded as phasor which is decomposed into a quadrature and an in-phase component $Q_i$, $IN_i$ (see signal processing block 301). These components $Q_i$, $IN_i$ may be weighted by time-variant weighing factors a and b, respectively, and then summed (complex number addition,i.e. $IN_i + j \cdot Q_i$, j being the imaginary unit) to obtain the modified (optimized) phasor represented by the triple $f_i'$, $A_i'$, $\varphi_i'$.

The weighing factors a, b are determined by the LMS optimization block 302. The optimization block 302 is configured to adjust the weighing factors a and b such that an error signal is minimized (in a least square sense, i.e. an $\ell^2$ norm of the signal is minimized). The residual signal $R(e^{j\omega})$ obtained using the residual extraction 60 shown in FIG. 3 may be used as error signal. That is, the "goal" of the adaptation is to minimize the power of the residual signal $R(e^{j\omega})$ and to maximize the total power of the harmonic signal component. The actual optimization algorithm may be any appropriate minimization algorithms, particularly an LMS algorithm, which is based on the "steepest gradient" method. All these methods are themselves known and therefore not discussed in detail here.

The signal analysis illustrated in FIGs. 1 to 3 may be performed "off-line", e.g. with a test car on a chassis roller dynamometer. The mentioned model parameters (i.e., frequency, amplitude and phase vectors f, A, and φ as well as the residual model parameters) may be measured for various different rpm values of the engine of the car. For example, the model parameters may be determined for discrete rpm values ranging from a minimum value (e.g. 900 rpm) to a maximum value (e.g. 6000 rpm) in intervals of e.g. 100 rpm. If for later sound synthesis the model parameters are required for an intermediate rpm value (e.g. 2575 rpm), the model parameters may be obtained by interpolation. In the present example the model parameters for 2575 rpm may be calculated from the model parameters determined for 2500 rpm and 2600 rpm using linear interpolation.

In order to determine the model parameters, the rotational speed of the engine of the car under test may be continuously ramped up from the minimum to the maximum rpm value. In this case the model parameters determined for rpm values within a given interval (e.g. from 950 rpm to 1049 rpm) may be averaged and associated with the center value of the interval (e.g. 1000 rpm in the present example). If other or additional guide signals (e.g. engine load) are to be considered, the data acquisition and model parameter estimation is performed analogously to the case described with regard to the rpm signal as guide signal. FIG. 5 is a block diagram illustrating the engine sound synthesis that makes use of the model parameters determined in accordance with the signal analysis illustrated in FIGs. 1 to 3. In the present example, only one guide signal (namely the rpm signal rpm[n]) is used. However, other guide signals may be used additionally or alternatively. The guide signal rpm[n] is supplied to the harmonic signal generator 110 and to the model parameter database 100. The signal generator 110 is be configured to provide the fundamental frequency $f_0$ and the frequencies $f_1$, $f_2$, etc. of the higher harmonics. These frequency values or, in other words, the frequency vector f=[$f_0$, $f_1$, ..., $f_N$] are supplied to the harmonic signal synthesizer 130. The synthesizer 130 also receives the harmonic model parameters which fit to the current guide signal rpm[n] from the model parameter database 100. The model parameter database 100 also provides the model parameters which describe the residual model, e.g. the power spectrum of the residual signal. Further, the model parameter database 100 may use interpolation to obtain the correct parameters as already mentioned above. The harmonic signal synthesizer 130 is configured to provide a harmonic signal $H_{est}(e^{j\omega})$ that corresponds to the harmonic content of the input signal $X(e^{j\omega})$ which has been estimated therefrom using the signal analysis as described above with respect to FIGs. 1 to 3.

The model parameters describing the residual signal may be provided to the envelope synthesizer 140 which recovers the magnitude $M(e^{j\omega})$ of the residual signal. In the present example the phase of the residual signal is recovered by all-pass filtering white noise (thus obtaining the phase signal $P(e^{j\omega})$) and adding the phase signal $P(e^{j\omega})$ to the magnitude signal $M(e^{j\omega})$ so as to generate the total residual signal $R_{est}(e^{j\omega})$. The white noise may be generated by a noise generator 120. The all-pass filter 150 may implement a phase filter by mapping the white noise supplied to the filter input into the phase region 0 to 2π thus providing the phase signal $P(e^{j\omega})$. The synthesized engine sound signal $X_{est}(e^{j\omega})$ may be obtained by adding the recovered harmonic signal $H_{est}(e^{j\omega})$ and the recovered residual signal $R_{est}(e^{j\omega})$. The resulting sound signal in the frequency domain may be transformed to the time domain, amplified and reproduced using common audio reproduction devices.

Below some aspects of the invention are summarized. It should be noted, however, that the following discussion is not regarded to be exhaustive or complete. One aspect relates to a method for analyzing sound, particularly engine sound signals picked up near a combustion engine. The method includes determining a fundamental frequency of an input signal to be analysed, thereby making use of the input signal or at least one guide signal. Furthermore, the frequencies of higher harmonics of the fundamental frequency are determined, thus obtaining harmonic model parameters. The method further includes synthesizing a harmonic signal based on the harmonic model parameters and subtracting the harmonic signal from the input signal to obtain a residual signal. Finally, residual model parameters are estimated based on the residual signal.

The input signal may be transformed to the frequency domain, thus providing a frequency domain input signal, before being further processed. In this case the number of higher harmonics which can be considered is only limited to the length of the input vectors used, e.g., by the FFT (fast Fourier transform) algorithm that provides the transformation into the frequency domain. Generally, the processing of input signal may be fully performed in the frequency domain and thus the harmonic signal and the residual signal may also be calculated in the frequency domain.

The fundamental frequency and the frequencies of the higher harmonics may be derived from the at least one guide signal, in order to avoid an estimation of the fundamental frequency (and of the frequencies of the higher harmonics) directly from the input signal which typically is computationally complex.

The harmonic model parameters may include a frequency vector of the fundamental frequency and the frequencies of the higher harmonics, a corresponding amplitude vector, and a corresponding phase vector. Determining the harmonic model parameters includes estimating phase and amplitude values associated with the fundamental frequency and the frequencies of higher harmonics. Generally, determining the harmonic model parameters may include a fine-tuning of the fundamental frequency and the frequencies of the higher harmonics obtained from the at least one guide signal. Such fine-tuning may entail an iterative modification of the frequencies of higher harmonics and their corresponding (estimated) amplitude and phase values such that a norm of the residual signal is minimized, e.g. an $L^2$ norm. This fine-tuning can be regarded as a kind of optimisation process.

The residual signal may be filtered using a non-linear filter to smooth the residual signal before estimating the residual model parameters. Determining the residual model parameters may include calculating the power spectrum of the residual signal. The power spectral density may be calculated for different frequency bands in accordance to a psycho-acoustically motivated frequency scale so as to consider psycho-acoustically critical band limits.

Another aspect relates to a method for synthesizing a sound signal based on harmonic model parameters and residual model parameters, wherein the parameters may particularly be determined in accordance with the method summarized above. The method includes the calculation of the fundamental frequency and frequencies of a number of higher harmonics based on the at least one guide signal. The residual model parameters and the harmonic model parameters that are associated with the calculated frequencies are provided, and a harmonic signal is synthesized using the harmonic model parameters for the calculated fundamental frequency and frequencies of higher harmonics. Furthermore, a residual signal is synthesized using the residual model parameters. The total sound signal may be calculated by superposing the synthesized harmonic signal and residual signal.

Pre-filtered white noise may be added to the total sound signal. Particularly, the pre-filtering may include the mapping of amplitude values of the white noise into the 0 to $2\pi$ phase range, thus generating a phase signal to be added to the total sound signal. Generally, synthesizing the residual signal may include the generation of a noise signal having a power spectral density which corresponds to a power spectral density represented by the residual model parameters.

Although various exemplary embodiments have been disclosed, it will be apparent to those skilled in the art that changes and modifications can be made according to a specific implementation of the various embodiments and without departing from the scope of the appended claims. It will be obvious to those reasonably skilled in the art that other components performing the same functions may be suitably substituted. Particularly, signal processing functions may be performed either in the time domain or in the frequency domain while achieving substantially equal results. It should be mentioned that features explained with reference to a specific figure may be combined with features of other figures, even in those where not explicitly been mentioned. Further, the methods of the invention may be achieved in either all software implementations, using the appropriate processor instructions, or in hybrid implementations that utilize a combination of hardware logic and software logic to achieve the same results. Such modifications to the concept are intended to be covered by the appended claims.

## Claims

1. A method for analyzing engine sound to obtain harmonic and residual model parameters for synthesizing the engine sound; the method comprising:

providing an input signal representing the engine sound to be analyzed (10);
determining a fundamental frequency of the input signal using one or more guide signals (30), and determining the frequencies, magnitudes, and phases of higher harmonics of the fundamental frequency, thus determining the harmonic model parameters associated with the determined frequencies (30), wherein the one or more guide signals include a rotational speed signal of the engine;
synthesizing a harmonic signal based on the harmonic model parameters (50);
determining a residual signal by subtracting the harmonic signal from the input signal (60);
calculating the residual model parameters based on the residual signal (80).

**2.** The method of claim 1, wherein the input signal is transformed to the frequency domain, thus providing a frequency domain input signal before being further processed.

**3.** The method of claim 2, wherein the processing of the frequency domain input signal is fully performed in the frequency domain and thus the harmonic signal and the residual signal are calculated in the frequency domain.

**4.** The method of claim 1, 2 or 3, wherein the fundamental frequency and the frequencies of the higher harmonics are derived from the one or more guide signals.

**5.** The method of claim 4, wherein determining the harmonic model parameters includes:
fine-tuning the fundamental frequency and the frequencies of the higher harmonics obtained from the one or more guide signals.

**6.** The method of claim 5, wherein the fine-tuning includes:
iteratively modifying the determined frequencies of higher harmonics and their corresponding amplitude and phase values such that a norm of the residual signal is minimized.

**7.** The method of one of the claims 4 to 6, wherein the harmonic model parameters include a frequency vector of the fundamental frequency and the frequencies of the higher harmonics, a corresponding magnitude vector, and a corresponding phase vector.

**8.** The method of one of the claims 1 to 7, further including
filtering the residual signal to smooth the residual signal before estimating the residual model parameters.

**9.** The method of one of the claims 1 to 8, wherein determining the residual model parameters includes
calculating the power spectrum of the residual signal.

**10.** The method of one of the claims 1 to 8, wherein determining harmonic model parameters includes estimating phase and amplitude values associated with the fundamental frequency and the frequencies of higher harmonics.

**11.** A method for synthesizing an engine sound signal based on harmonic model parameters that include phase and amplitude values associated to frequency values and residual model parameters , the method comprises:

receiving, as guide signal(s), a rotational speed signal of the engine or the rotational speed signal and at least one further guide signal;
calculating frequency values for a fundamental frequency and frequencies of a number of higher harmonics based on the guide signal(s) (110);
providing the residual model parameters and the harmonic model parameters which are associated with the calculated frequency values (100);
synthesizing a harmonic signal using the harmonic model parameters for the calculated fundamental frequency and frequency values of higher harmonics (130);
synthesizing a residual signal using the residual model parameters (140);
calculating the engine sound signal by superposing the synthesized harmonic signal and residual signal.

**12.** The method of claim 11, further comprising:
adding pre-filtered white noise to the engine sound signal.

**13.** The method of claim 12, wherein the pre-filtering includes the mapping of amplitude values of the white noise into the 0 to $2\pi$ phase range thus generating a phase signal to be added to the engine sound signal.

**14.** The method of one of the claims 11 to 13, wherein synthesizing the residual signal includes:
generating a noise signal having a power spectral density which corresponds to a power spectral density represented by the residual model parameters.

**15.** The method of claim 9 or 14, wherein the power spectral density is calculated for different frequency bands in accordance to a psycho-acoustically motivated frequency scale so as to consider psycho-acoustically critical band limits.

**Patentansprüche**

**1.** Verfahren zum Analysieren von Motorgeräuschen, um Harmonie- und Restmodellparameter für die Synthese der Motorgeräusche zu erhalten; wobei das Verfahren Folgendes umfasst:

Bereitstellen eines Eingangssignals, das die zu analysierenden Motorgeräusche repräsentiert (10);
Bestimmen einer Grundfrequenz des Eingangssignals unter Verwendung eines oder mehrerer Führungssignale (30),
und Bestimmen der Frequenzen, Größen und Phasen von höheren Harmonien der Grundfrequenz, wodurch die Harmoniemodellparameter in Verbindung mit den bestimmten Frequenzen bestimmt werden (30);
wobei das eine oder die mehreren Führungssignale ein Drehzahlsignal des Motors beinhalten;
Synthetisieren eines harmonischen Signals auf Grundlage der Harmoniemodellparameter (50);
Bestimmen eines Restsignals durch Subtrahieren des harmonischen Signals von dem Eingangssignal (60);
Berechnen der Restmodellparameter auf Grundlage des Restsignals (80) .

**2.** Verfahren nach Anspruch 1, wobei das Eingangssignal in die Frequenzdomäne umgewandelt wird, wodurch ein Frequenzdomäneneingangssignal bereitgestellt wird, bevor es weiterverarbeitet wird.

**3.** Verfahren nach Anspruch 2, wobei die Verarbeitung des Frequenzdomäneneingangssignals vollständig in der Frequenzdomäne durchgeführt wird und damit das harmonische Signal und das Restsignal in der Frequenzdomäne berechnet werden.

**4.** Verfahren nach Anspruch 1, 2 oder 3, wobei die Grundfrequenz und die Frequenzen der höheren Harmonien von dem einen oder den mehreren Führungssignalen abgeleitet werden.

**5.** Verfahren nach Anspruch 4, wobei das Bestimmen der Harmoniemodellparameter Folgendes beinhaltet:
Feineinstellen der Grundfrequenz und der Frequenzen der höheren Harmonien, die von dem einen oder den mehreren Führungssignalen erhalten werden.

**6.** Verfahren nach Anspruch 5, wobei das Feineinstellen Folgendes beinhaltet:
iteratives Modifizieren der bestimmten Frequenzen von höheren Harmonien und ihrer entsprechenden Amplitude und Phasenwerte, sodass eine Norm des Restsignals minimiert wird.

**7.** Verfahren nach einem der Ansprüche 4 bis 6, wobei die Harmoniemodellparameter einen Frequenzvektor der Grundfrequenz und der Frequenzen der höheren Harmonien, einen entsprechenden Größenvektor und einen entsprechenden Phasenvektor beinhalten.

**8.** Verfahren nach einem der Ansprüche 1 bis 7, ferner beinhaltend:
Filtern des Restsignals, um das Restsignal zu glätten, bevor die Restmodellparameter geschätzt werden.

**9.** Verfahren nach einem der Ansprüche 1 bis 8, wobei das Bestimmen der Restmodellparameter Folgendes beinhaltet:
Berechnen des Leistungsspektrums des Restsignals.

**10.** Verfahren nach einem der Ansprüche 1 bis 8, wobei das Bestimmen von Harmoniemodellparametern das Schätzen von Phasen- und Amplitudenwerten in Verbindung mit der Grundfrequenz und den Frequenzen höherer Harmonien beinhaltet.

**11.** Verfahren zum Synthetisieren eines Motorgeräuschsignals auf Grundlage von Harmoniemodellparametern, die Phasen- und Amplitudenwerte in Verbindung mit Frequenzwerten und Restmodellparametern beinhalten, wobei das Verfahren Folgendes umfasst:

Empfangen, als Führungssignal(e), eines Drehzahlsignals des Motors oder des Drehzahlsignals und mindestens eines weiteren Führungssignals;
Berechnen von Frequenzwerten für eine Grundfrequenz und Frequenzen einer Anzahl von höheren Harmonien auf Grundlage des Führungssignals/der Führungssignale (110);
Bereitstellen der Restmodellparameter und der Harmoniemodellparameter, die mit den berechneten Frequenzwerten verbunden sind (100);
Synthetisieren eines harmonischen Signals unter Verwendung der Harmoniemodellparameter für die berechnete(n) Grundfrequenz und Frequenzwerte höherer Harmonien (130);
Synthetisieren eines Restsignals unter Verwendung der Restmodellparameter (140);
Berechnen des Motorgeräuschsignals durch Überlagern des synthetisierten harmonischen Signals und Restsignals.

**12.** Verfahren nach Anspruch 11, ferner umfassend:
Hinzufügen von vorgefiltertem weißen Rauschen zu dem Motorgeräuschsignal.

**13.** Verfahren nach Anspruch 12, wobei das Vorfiltern das Darstellen von Amplitudenwerten des weißen Rauschens in die Phasenspanne von 0 bis 2 $\pi$ beinhaltet, wodurch ein dem Motorgeräuschsignal hinzuzufügendes Phasensignal erzeugt wird.

**14.** Verfahren nach einem der Ansprüche 11 bis 13, wobei das Synthetisieren des Restsignals Folgendes beinhaltet:
Erzeugen eines Geräuschsignals, das eine Leistungsspektraldichte aufweist, die durch die Restmodellparameter dargestellt wird.

**15.** Verfahren nach Anspruch 9 oder 14, wobei die Leistungsspektraldichte in verschiedenen Frequenzbändern gemäß einer psychoakustisch motivierten Frequenzskala berechnet wird, um psychoakustisch kritische Bandgrenzen zu berücksichtigen.

**Revendications**

**1.** Procédé d'analyse de son moteur pour obtenir des paramètres de modèle harmonique et résiduel pour la synthétisation du son moteur ; le procédé comprenant :

la fourniture d'un signal d'entrée représentant le son moteur à analyser (10) ;
la détermination d'une fréquence fondamentale du signal d'entrée en utilisant un ou plusieurs signaux de guidage (30), et la détermination des fréquences, amplitudes et phases d'harmoniques supérieurs de la fréquence fondamentale, déterminant ainsi les paramètres de modèle harmonique associés aux fréquences déterminées (30) ;
dans lequel les un ou plusieurs signaux de guidage comprennent un signal de vitesse de rotation du moteur :

la synthétisation d'un signal harmonique sur la base des paramètres de modèle harmonique (50) ;
la détermination d'un signal résiduel par soustraction du signal harmonique du signal d'entrée (60) ;
le calcul des paramètres de modèle résiduel sur la base du signal résiduel (80).

**2.** Procédé selon la revendication 1, dans lequel le signal d'entrée est transformé en domaine de fréquence, fournissant ainsi un signal d'entrée de domaine de fréquence avant d'être traité ultérieurement.

**3.** Procédé selon la revendication 2, dans lequel le traitement du signal d'entrée de domaine de fréquence est entièrement réalisé dans le domaine de fréquence et ainsi le signal harmonique et le signal résiduel sont calculés dans le domaine de fréquence.

**4.** Procédé selon la revendication 1, 2 ou 3, dans lequel la fréquence fondamentale et les fréquences des harmoniques supérieurs sont dérivées des un ou plusieurs signaux de guidage.

**5.** Procédé selon la revendication 4, dans lequel la détermination des paramètres de modèle harmonique comprend : le réglage fin de la fréquence fondamentale et des fréquences des harmoniques supérieurs obtenues des un ou plusieurs signaux de guidage.

**6.** Procédé selon la revendication 5, dans lequel le réglage fin comprend :
la modification itérative des fréquences déterminées d'harmoniques supérieurs et de leurs valeurs de phase et d'amplitude correspondantes de sorte qu'une norme du signal résiduel est minimisée.

**7.** Procédé selon l'une des revendications 4 à 6, dans lequel les paramètres de modèle harmonique comprennent un vecteur de fréquence de la fréquence fondamentale et des fréquences des harmoniques supérieurs, un vecteur d'amplitude correspondant, et un vecteur de phase correspondant.

**8.** Procédé selon l'une des revendications 1 à 7, comprenant en outre
le filtrage du signal résiduel pour lisser le signal résiduel avant l'estimation des paramètres de modèle résiduel.

**9.** Procédé selon l'une des revendications 1 à 8, dans lequel la détermination des paramètres de modèle résiduel comprend le calcul du spectre de puissance du signal résiduel.

**10.** Procédé selon l'une des revendications 1 à 8, dans lequel la détermination de paramètres de modèle harmonique comprend l'estimation de valeurs de phase et d'amplitude associées à la fréquence fondamentale et aux fréquences d'harmoniques supérieurs.

**11.** Procédé de synthétisation d'un signal de son moteur sur la base de paramètres de modèle harmonique qui comprennent des valeurs de phase et d'amplitude associées à des valeurs de fréquence et paramètres de modèle résiduel, le procédé comprenant :

la réception, en tant que signal(signaux) de guidage, d'un signal de vitesse de rotation du moteur ou du signal de vitesse de rotation et d'au moins un autre signal de guidage ;
le calcul de valeurs de fréquence pour une fréquence fondamentale et des fréquences d'un nombre d'harmoniques supérieurs sur la base du(des) signal(signaux) de guidage (110) ;
la fourniture des paramètres de modèle résiduel et des paramètres de modèle harmonique qui sont associés aux valeurs de fréquence calculées (100) ;
la synthétisation d'un signal harmonique en utilisant les paramètres de modèle harmonique pour les valeurs de fréquence fondamentale et de fréquence calculées d'harmoniques supérieurs (130) ;
la synthétisation d'un signal résiduel en utilisant les paramètres de modèle résiduel (140) ;
le calcul du signal de son moteur par superposition du signal harmonique et signal résiduel synthétisés.

**12.** Procédé selon la revendication 11, comprenant en outre :
l'ajout de bruit blanc préfiltré au signal de son moteur.

**13.** Procédé selon la revendication 12, dans lequel le préfiltrage comprend le mappage de valeurs d'amplitude du bruit blanc dans la plage de phase 0 à 2 générant ainsi un signal de phase à ajouter au signal de son moteur.

**14.** Procédé selon l'une des revendications 11 à 13, dans lequel la synthétisation du signal résiduel comprend :
la génération d'un signal de bruit ayant une densité spectrale de puissance qui correspond à une densité spectrale de puissance représentée par les paramètres de modèle résiduel.

**15.** Procédé selon la revendication 9 ou 14, dans lequel la densité spectrale de puissance est calculée pour différentes bandes de fréquence selon une échelle de fréquence motivée psychoacoustiquement de façon à prendre en compte des limites de bande critiques psychoacoustiquement.

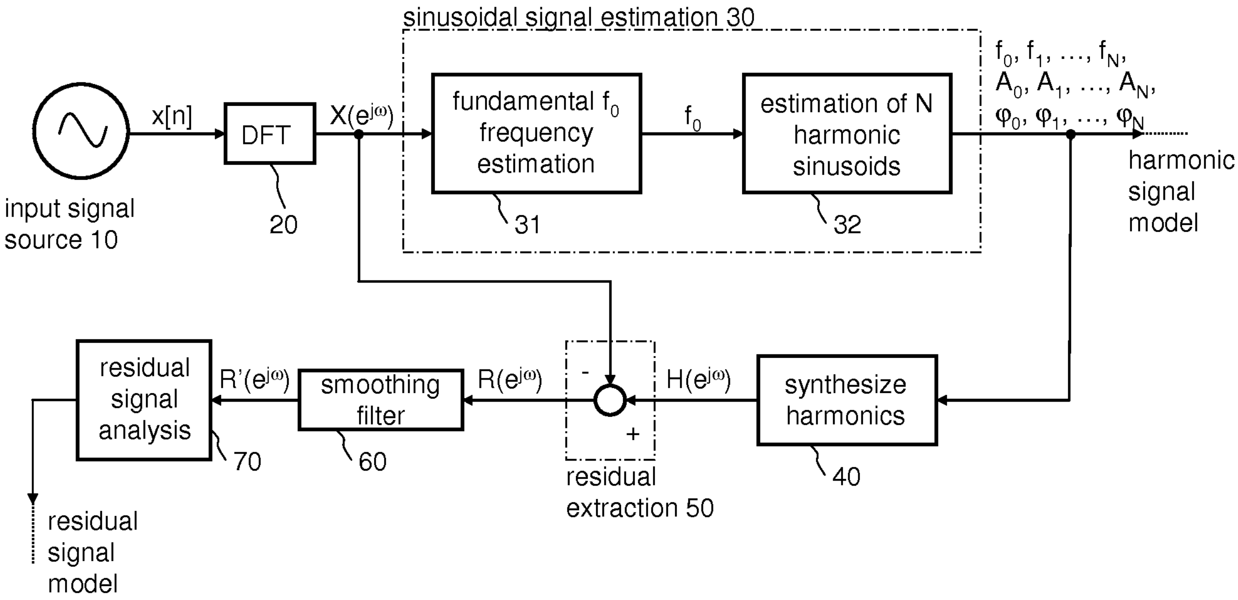
sinusoidal signal estimation 30
x[n]
DFT
X(e^jω)
fundamental f0 frequency estimation
f0
estimation of N harmonic sinusoids
f0, f1, ..., fN,
A0, A1, ..., AN,
φ0, φ1, ..., φN
harmonic signal model
input signal source 10
20
31
32
residual signal analysis
R'(e^jω)
smoothing filter
R(e^jω)
-
+
H(e^jω)
synthesize harmonics
70
60
residual extraction 50
40
residual signal model

FIG. 1

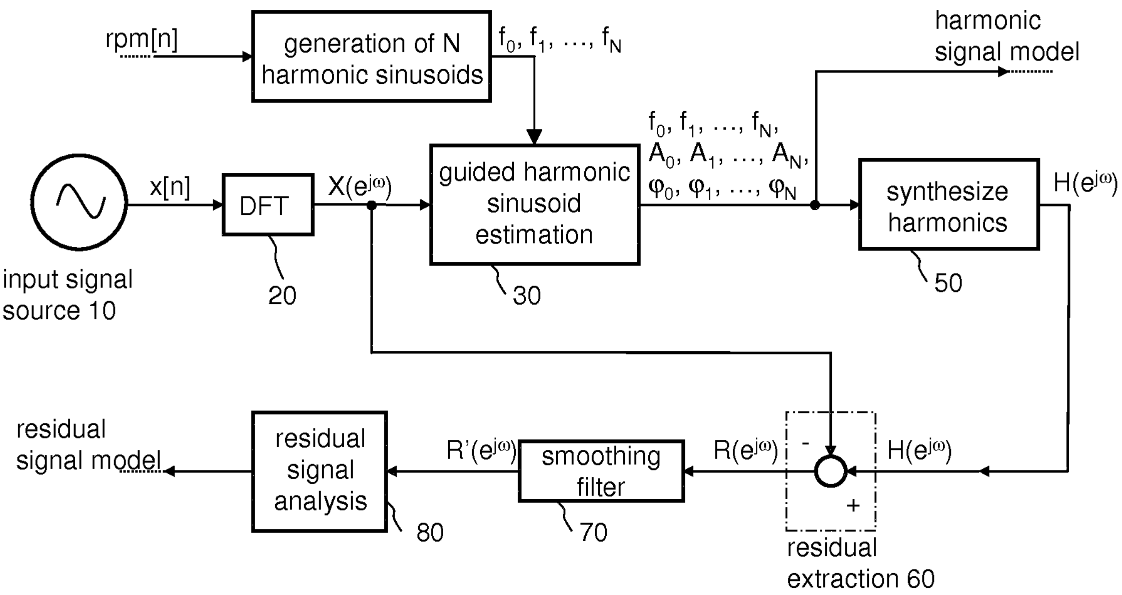
rpm[n]
generation of N harmonic sinusoids
f0, f1, ..., fN
harmonic signal model
f0, f1, ..., fN,
A0, A1, ..., AN,
φ0, φ1, ..., φN
x[n]
DFT
X(e^jω)
guided harmonic sinusoid estimation
synthesize harmonics
H(e^jω)
input signal source 10
20
30
50
residual signal model
residual signal analysis
R'(e^jω)
smoothing filter
R(e^jω)
-
+
H(e^jω)
80
70
residual extraction 60

FIG. 2

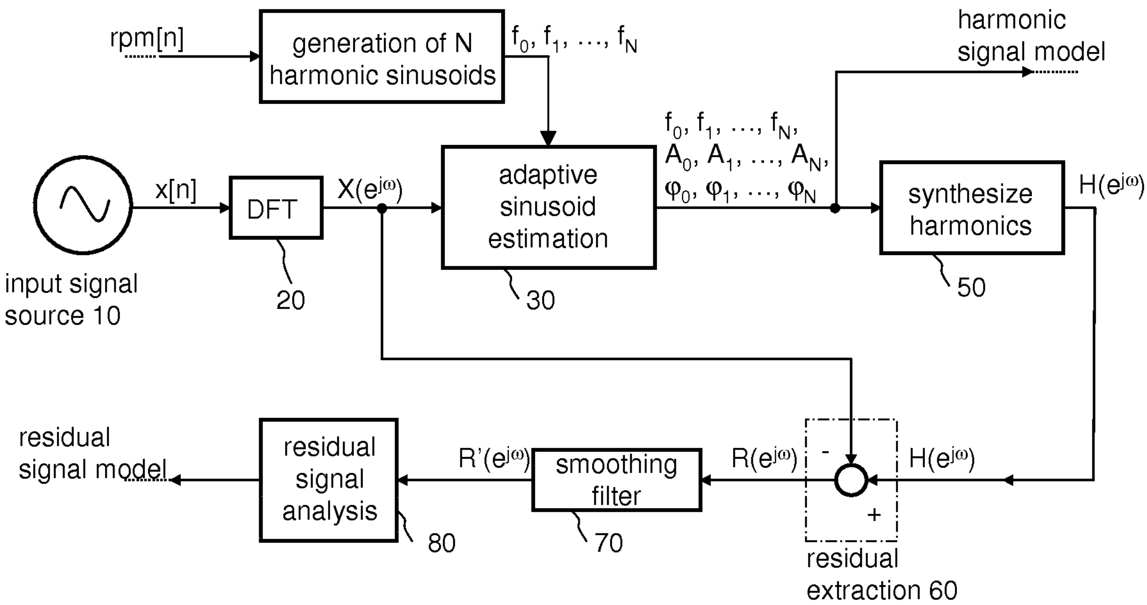
rpm[n]
generation of N harmonic sinusoids
$f_0, f_1, \ldots, f_N$
harmonic signal model
x[n]
DFT
$X(e^{j\omega})$
adaptive sinusoid estimation
$f_0, f_1, \ldots, f_N,$
$A_0, A_1, \ldots, A_N,$
$\varphi_0, \varphi_1, \ldots, \varphi_N$
synthesize harmonics
$H(e^{j\omega})$
input signal source 10
20
30
50
residual signal model
residual signal analysis
$R'(e^{j\omega})$
smoothing filter
$R(e^{j\omega})$
-
+
$H(e^{j\omega})$
80
70
residual extraction 60

FIG. 3

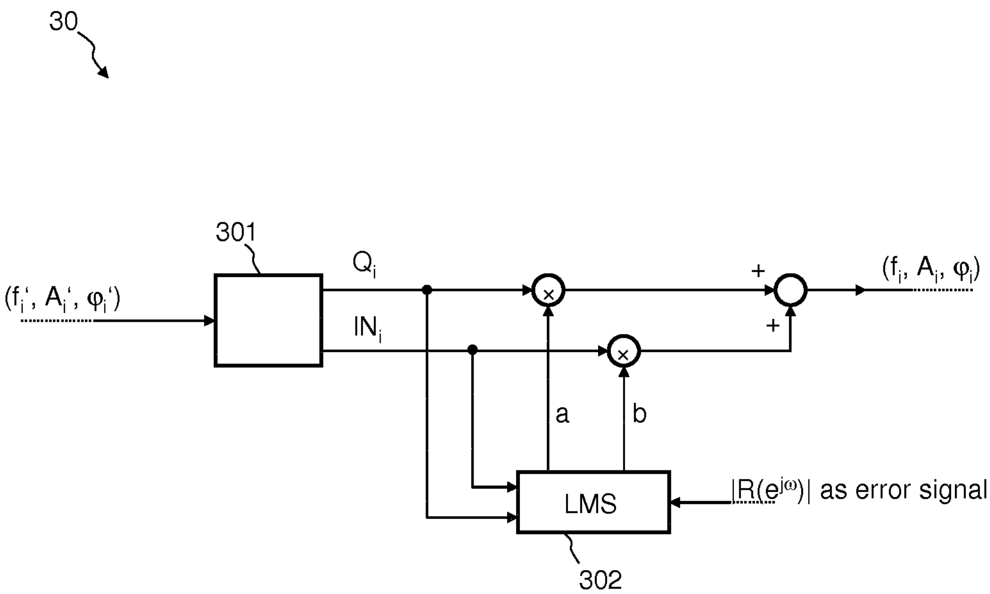
30
301
$Q_i$
$(f_i', A_i', \varphi_i')$
$IN_i$
+
+
$(f_i, A_i, \varphi_i)$
a
b
LMS
$|R(e^{j\omega})|$ as error signal
302

FIG. 4

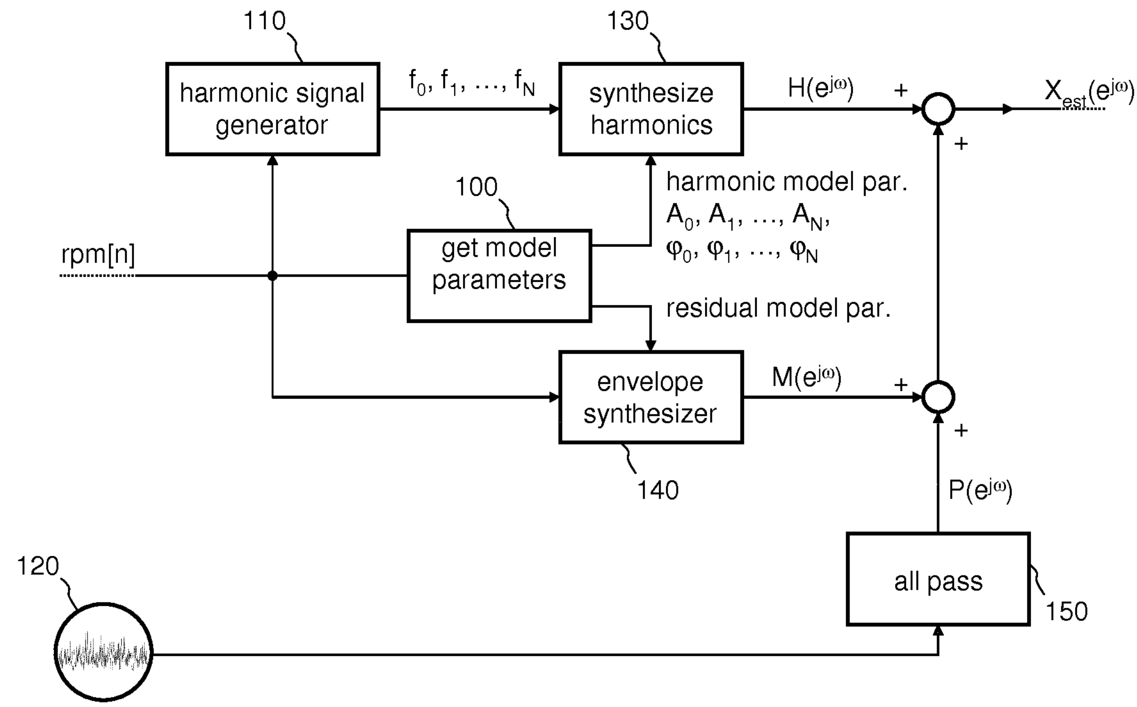
110
harmonic signal generator
$f_0, f_1, \ldots, f_N$
130
synthesize harmonics
$H(e^{j\omega})$
+
+
$X_{est}(e^{j\omega})$
100
get model parameters
harmonic model par.
$A_0, A_1, \ldots, A_N,$
$\varphi_0, \varphi_1, \ldots, \varphi_N$
rpm[n]
residual model par.
envelope synthesizer
$M(e^{j\omega})$
+
+
140
$P(e^{j\omega})$
120
all pass
150

FIG. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 0133543 A1
- US 5410606 A
- EP 1577879 A1
- WO 2009028790 A1


### Non-patent literature cited in the description


- **S. M. KUO.** Frequency-Domain Periodic Active Noise Control and Equalization. *IEEE Trans. on Speech and Audio Processing,* 1997, vol. 5 (4), 348-358
- **D. P. DAS ; G. PANDA ; S. M. KUO.** New block filtered-X LMS algorithms for active noise control systems. *IET Signal Processing,* 2007, vol. 1 (2), 73-81
- **FASTL, HUGO ; ZWICKER, EBERHARD.** Psychoacoustics. Springer, 2007
- Applications of Signal Processing to Audio and Acoustics. **CHRISTINE SMIT ; DANIEL P. W. ELLIS.** GUIDED HARMONIC SINUSOID ESTIMATION IN A MULTI-PITCH ENVIRONMENT. IEEE Workshop, 18 October 2009